# EUROPÄISCHE PATENTSCHRIFT

(11) **EP 3 547 337 B1**
(45) Veröffentlichungstag und Bekanntmachung des Hinweises auf die Patenterteilung: **20.01.2021**
(21) Anmeldenummer: 19160728.2
(22) Anmeldetag: 05.03.2019
(51) Int. Cl.: H01F 27/06, H01F 27/29, H01F 27/02

(54) **POSITIONIERUNGS- UND MONTAGEHILFE FÜR SPULEN AUF LEITERPLATTEN**
POSITIONING AND MOUNTING AID FOR COILS ON PRINTED CIRCUIT BOARDS
AIDE AU POSITIONNEMENT ET AU MONTAGE POUR BOBINES SUR CARTES DE CIRCUIT IMPRIMÉ

(30) Priorität: 14.03.2018 DE 202018101423 U
(43) Veröffentlichungstag der Anmeldung: 02.10.2019
(73) Patentinhaber: Tridonic GmbH & Co. KG, 6851 Dornbirn (AT)
(72) Erfinder: Maldoner, Jakob, 6655 Steeg (AT); Marte, Patrick, 6840 Götzis (AT); Schertler, Markus, 6952 Hittisau (AT); Wynnyczenko, Oliver, 6890 Lustenau (AT)
(74) Vertreter: Beder, Jens

(56) Entgegenhaltungen:
- DE-A1- 10 124 117
- DE-B- 1 257 233
- JP-A- 2003 257 749
- JP-U- H0 634 212
- US-A1- 2011 254 648
- US-A1- 2017 164 480
- US-B1- 7 446 637

## Beschreibung

Die vorliegende Erfindung betrifft ein induktives Bauelement, wie eine Spule, einen Übertrager oder Transformator, zum Einlöten auf eine Leiterplatte und eine Leiterplatte mit einem solchen induktiven Bauelement.

Von den auf Leiterplatten befindlichen Bauelementen sind die Spulen die Bauelemente, welche einen großen Einfluss auf die Baugröße der Leiterplatte insbesondere deren Dicke haben. Bei vielen Anwendungen sollen die mit Bauelementen bestückten Leiterplatten möglichst flach sein. Spulen mit geringer Bauhöhe sind jedoch teuer. Zudem müssen große Spulen meist von Hand auf der Leiterplatte verlötet werden, wobei die Positionierung für das Löten schwierig ist.

Ein induktives Bauelement gemäß dem Oberbegriff des beigefügten Anspruches 1 ist in der JP 2003 257749 A beschrieben.

Die JP H06 34212 U offenbart einen Abstandhalter für ein auf eine Leiterplatte gelötetes induktives Bauelement, der Bohrungen, durch die die Anschluss-Drähte des Bauelements hindurchführt sind, aufweist.

Ein induktives Bauelement mit einem Gehäuse und einem an dem Gehäuse angeordneten Abstandhalter zum Positionieren des Bauelements auf einer Leiterplatte bezüglich der Höhe ist aus der US 7 446 637 B1 bekannt.

Die US 2017/164480 A1 offenbart einen als Kappe ausgebildeten Abstandhalter für ein auf eine Leiterplatte gelötetes induktives Bauelement.

Eine Leiterplatte mit einem Ausschnitt, in dem ein induktive Bauelement angeordnet ist, wird in der US 2011/254648 A1 beschrieben.

Die DE 12 57 233 B offenbart ein Bauelement, das mit Montagefüßen aus thermoplastischem, bei Löthitze quellendem Kunststoff versehen ist, deren auf eine Leiterplatte aufsetzbaren Unterseiten zapfenförmige Vorsprünge haben, die in entsprechende Aussparungen in der Leiterplatte einsteckbar sind und dort festquellen, wenn die Leiterplatte zwecks Verlötung von Anschlussdrähten tauchgelötet wird.

Ein induktives Bauelement mit einem Abstandhalter zum Positionieren des Bauelements in einem Ausschnitt einer Leiterplatte bezüglich der Höhe ist aus der DE 101 24 117 A1 bekannt.

Der Erfindung liegt die Aufgabe zugrunde, Vorrichtungen anzugeben, die die beschriebenen Probleme verringern. Aufgabe ist es insbesondere, ein induktives Bauelement bereitzustellen, das eine niedrige Bauhöhe der mit ihm bestückten Leiterplatte erlaubt und einfach auf eine Leiterplatte aufgelötet werden kann sowie eine Leiterplatte mit einem induktiven Bauelement bereitzustellen, die eine niedrige Bauhöhe aufweist.

Diese Aufgabe wird gemäß den Merkmalen der unabhängigen Ansprüche gelöst. Die Erfindung wird durch die Merkmale der abhängigen Ansprüche weitergebildet.

Gemäß der vorliegenden Erfindung weist ein zum Einlöten auf eine Leiterplatte vorgesehenes induktives Bauelement seitlich angeordnete Anschluss-Drähte auf, wobei an zumindest einem der Anschluss-Drähte ein Abstandhalter zum Positionieren des Bauelements auf der Leiterplatte bezüglich der Höhe angeordnet ist. Der von dem Anschluss-Draht gehaltene Abstandhalter stützt sich an der Leiterplatte in einer Richtung senkrecht zur Leiterplatte ab, wenn das Bauelement zum Einlöten auf die Leiterplatte aufgesetzt wird. Das induktive Bauelement liegt vor und nach dem Löten mittels des Abstandhalters auf der Leiterplatte auf und wird durch diesen zumindest in der Höhe positioniert. Das Bauelement kann in einem Ausschnitt der Leiterplatte, einer für das Bauelement vorgesehenen Öffnung einsetzt werden, wobei die Höhe, mit der das Bauelement aus der Öffnung ragt, mittels des Abstandhalters definierbar ist. Dies vereinfacht das Verlöten des Bauelements in der gewünschten Position und erlaubt eine geringere Gesamt-Bauhöhe der mit dem induktiven Bauelement bestückten Leiterplatte. Da nur Abstandhalter an den bereits vorhandenen Anschluss-Drähten angebracht werden müssen, ist keine Änderung/Anpassung des Bauelements nötig. Durch Verwendung unterschiedlicher Abstandshalter lassen sich für ein Bauelement nach Bedarf unterschiedliche Einbaulagen realisieren.

Zur Befestigung weist der Abstandhalter eine Bohrung, durch die der Anschluss-Draht hindurchführt, auf, wobei das aus der Bohrung ragende Ende des Anschluss-Drahts in Richtung der Leiterplatte gebogen ist, so dass ein Abgleiten des Abstandhalters vom Anschluss-Draht verhindert wird und gleichzeitig der Höhenversatz bei der Montage auf der Leiterplatte kompensiert wird.

Zusätzlich kann der Abstandhalter zumindest einen Absatz aufweisen, mittels dem sich der Abstandhalter an der Leiterplatte in horizontaler Richtung abstützt, wenn das Bauelement zum Einlöten in einen Ausschnitt der Leiterplatte eingeführt ist, was der Anordnung zusätzliche mechanische Stabilität verleiht.

Alternativ oder zusätzlich können an gegenüberliegenden Seiten des Bauelements Anschluss-Drähte angeordnet sein, wobei jeweils ein Abstandhalter an jeder den gegenüberliegenden Seiten von den Anschluss-Drähten gehalten wird.

Zusätzlich kann das induktive Bauelement, ein Gehäuse und zumindest ein an dem Gehäuse angeordneten Abstandhalter aufweisen, wobei der an dem Gehäuse angeordnete Abstandhalter das Bauelement auf der Leiterplatte bezüglich der Höhe positioniert, in dem sich der an dem Gehäuse angeordnete Abstandhalter an der Leiterplatte in vertikaler Richtung abstützt, wenn das Bauelement zum Einlöten auf die Leiterplatte aufgesetzt ist. Das induktive Bauelement liegt vor und nach dem Löten mittels des an dem Gehäuse angeordneten Abstandhalters auf der Leiterplatte auf und wird durch diesen zumindest in der Höhe positioniert. Das Bauelement kann in einem Ausschnitt der Leiterplatte, einer für das Bauelement vorgesehenen Öffnung einsetzt werden, wobei die Höhe, mit der das Bauelement aus der Öffnung ragt, mittels des an dem Gehäuse angeordneten Abstandhalters definierbar ist. Dies vereinfacht das Verlöten des Bauelements in der gewünschten Position und erlaubt eine geringere Gesamt-Bauhöhe der mit dem induktiven Bauelement bestückten Leiterplatte.

Zumindest ein Abstandhalter kann Teil des Gehäuses bzw. an dem Gehäuse abgeformt sein. Beispielsweise kann der Abstandhalter eine Kante oder ein Vorsprung an dem Gehäuse sein, welche sich an der Leiterplatte in vertikaler Richtung abstützt, wenn das Bauelement zum Einlöten auf die Leiterplatte aufgesetzt ist. Da der Abstandhalter im Gehäuse integriert ist, wird kein zusätzliches Bauteil benötigt.

Alternativ kann der an dem Gehäuse angeordnete Abstandhalter eine an dem Gehäuse befestigte Hülse oder Kappe sein. Durch Verwendung unterschiedlicher Hülsen bzw. Kappen lassen sich für ein Bauelement nach Bedarf unterschiedliche Einbaulagen realisieren.

Alternativ oder zusätzlich können an gegenüberliegenden Seiten des Bauelements Anschluss-Drähte angeordnet sein, wobei sich der an dem Gehäuse angeordnete Abstandhalter jeweils zwischen den gegenüberliegenden Seiten an der Leiterplatte in vertikaler Richtung abstützt, wenn das Bauelement zum Einlöten auf die Leiterplatte aufgesetzt ist.

Das induktive Bauelement kann eine Planarspule oder ein Planartransformator sein.

Gemäß der vorliegenden Erfindung weist eine Leiterplatte zumindest eines der beschriebenen induktiven Bauelemente auf, wobei die Leiterplatte einen Ausschnitt aufweisen kann, in dem das induktive Bauelement angeordnet ist.

Nachfolgend wird die Erfindung anhand der beiliegenden Zeichnungen näher erläutert. Es zeigen:
- Fig. 1: eine Leiterplatte mit einem induktiven Bauelement nach einem ersten Ausführungsbeispiel gemäß der vorliegenden Erfindung in einer Seitenansicht,
- Fig. 2: die in Fig. 1 gezeigte Leiterplatte in der Sicht von oben,
- Fig. 3a: einen Abstandhalter nach einem ersten Ausführungsbeispiel gemäß der vorliegenden Erfindung,
- Fig. 3b: einen Abstandhalter nach einer Variation des ersten Ausführungsbeispiels gemäß der vorliegenden Erfindung
- Fig. 4: eine Leiterplatte mit einem induktiven Bauelement nach einer weiteren Variation des ersten Ausführungsbeispiels gemäß der vorliegenden Erfindung in einer Seitenansicht,
- Fig. 5: eine Leiterplatte mit einem induktiven Bauelement hilfreich für das Verständnis eines zweiten Ausführungsbeispiels gemäß der vorliegenden Erfindung in der Sicht von oben,
- Fig. 6: einen Schnitt entlang durch eine Anordnung nach der Fig. 5, und
- Fig. 7: eine Seitenansicht der Anordnung nach Fig. 5.

Komponenten mit gleichen Funktionen sind in den Figuren mit gleichen Bezugszeichen gekennzeichnet.

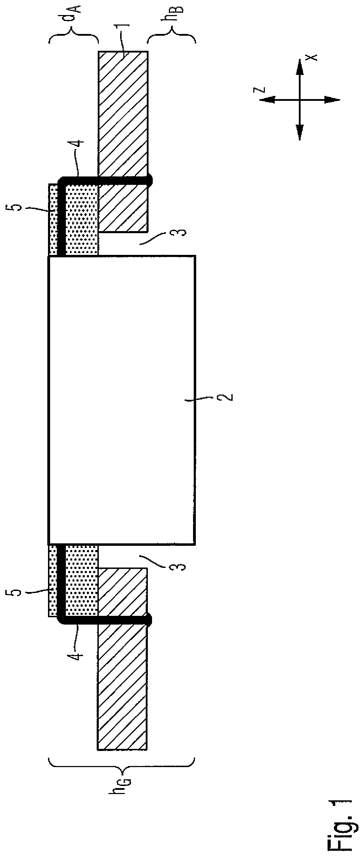

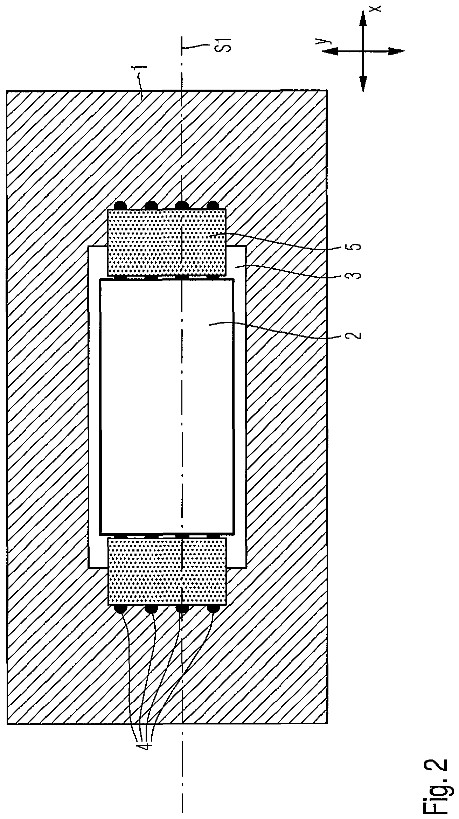

Fig. 1 zeigt eine Schnittdarstellung (Schnittlinie S1 in Fig. 2) einer Leiterplatte 1, auf der ein induktives Bauelement 2 gemäß der vorliegenden Erfindung verlötet ist. Das quaderförmige Bauelement 2 ragt von oben in einen Ausschnitt 3 der Leiterplatte 1 und weist an zwei seiner gegenüberliegenden Schmalseiten jeweils vier Anschluss-Drähte 4 auf. An jeder der Schmalseiten befindet sich ein auf die Anschluss-Drähte 4 aufgesteckter Abstandhalter 5. Die aus den Abstandhaltern 5 ragenden Enden der Anschluss-Drähte 4 sind in Richtung der Leiterplatte 1 nach unten gebogen, durch die Leiterplatte 1 geführt und verlötet. Damit ist es möglich, obwohl die Anschluss-Drähte ganz an einer Seite des Bauelements herausgeführt sind, was das Wickeln einer solchen Spule erleichtert, dennoch eine höhenzentrierte Einbaulage in der Leiterplatte zu erreichen.

Fig. 2 zeigt in einer Sicht von oben die Leiterplatte 1 mit dem in dem Ausschnitt 3 befindlichen Bauelement 2. Durch die Positionierung des Bauelements 2 in dem Ausschnitt 3 kann die Gesamthöhe h_{G} der mit Bauelementen 2 bestückten Leiterplatte 1 um die Höhe der unbestückten bestückten Leiterplatte 1 verringert werden und insbesondere die einseitige große Bauhöhe durch die Spule vermieden werden.

Wie in Fig. 1 gezeigt beeinflusst der von dem Abstandhalter 5 vorgegebene Abstand d_{A} zwischen dem Durchgang der Anschluss-Drähte 4 und der unteren Fläche des Abstandhalters 5 die Höhe h_{B}, mit der das Bauelement 2 nach unten (bzw. nach oben) aus der Leiterplatte 1 herausragt. In dem in Fig. 1 gezeigten Beispiel ist der Abstand d_{A} so gewählt, dass das Bauelement 2 und die Leiterplatte 1 mittig sind bzw. die gleich Mittellinie aufweisen. Der Abstand d_{A} kann je nach Bedarf auch so gewählt werden, dass die untere Fläche des Bauelements 2 und die untere Fläche der Leiterplatte 1 in einer Ebene liegen.

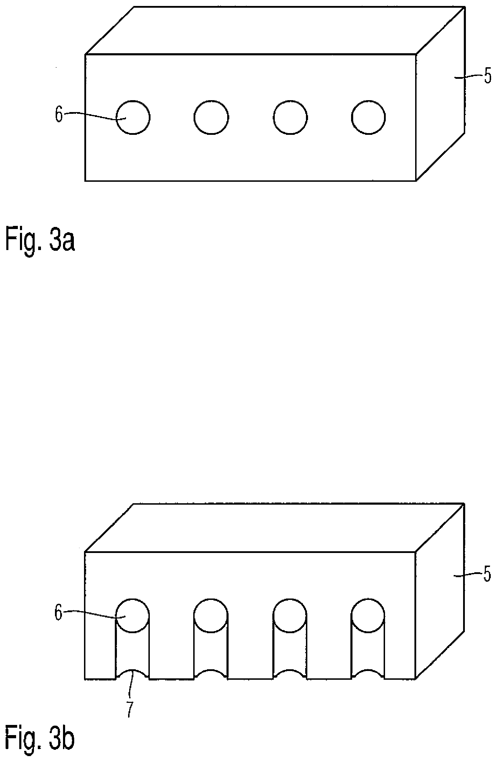

Fig. 3a zeigt einen auf die vier Anschluss-Drähte 4 aufschiebbaren Abstandhalter 5, bei dem vier Durchgangslöcher 6 in der Höhe mittig angeordnet sind. Durch diese Durchgangslöcher 6 werden die vier Anschluss-Drähte 4 geführt und die aus den Durchgangslöchern 6 ragenden Enden der Anschluss-Drähte 4 in Richtung der Leiterplatte 1 gebogen, was den Abstandhalter 5 auf den Anschluss-Drähten 4 fixiert. Der Abstandhalter 5 besteht aus einem festen und elektrisch isolierenden Material, z.B. dem Kunststoff PVC.

Fig. 3b zeigt eine andere Ausführung des Abstandhalters 5, bei dem für die Aufnahme der umgebogenen Enden der Anschluss-Drähte 4 Vertiefungen 7 (Kerben) vorgesehen sind. Die Vertiefungen 7 können als Biegehilfe/-Führung dienen und nach dem Biegen einschließlich der Anschluss-Drähte 4 verschlossen werden. Es ist auch möglich anstelle der Durchgangslöchern 6 auf der Oberseite des Abstandhalters 5 Vertiefungen 7 (Kerben, Nuten) vorzusehen.

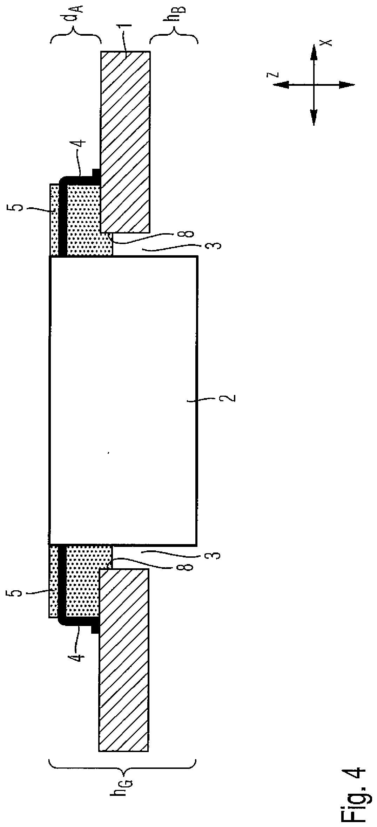

Bei der in Fig. 4 gezeigten Variante des ersten Ausführungsbeispiels gemäß der vorliegenden Erfindung sind die an den kurzen Seiten des Bauelement 2 befindlichen Anschluss-Drähte 4 nicht durch die Leiterplatte 1 geführt sondern liegen beim Verlöten auf der Oberseite der Leiterplatte 1 auf. Für eine exakte Positionierung der Anschluss-Drähte 4 (Pins) an den zugehörigen Lötpunkten weisen die Abstandhalter 5 an ihrer Unterseite einen Absatz 8 auf, mittels dem das Bauelement 2 in horizontaler Richtung (x-Richtung) gegenüber der Leiterplatte 1 positioniert wird. Zusätzlich oder alternativ kann ein weiterer Absatz (Anschlag) an der Unterseite vorgesehen sein, mittels dem das Bauelement 2 in der in Fig. 1 gezeigten x-Richtung positioniert wird.

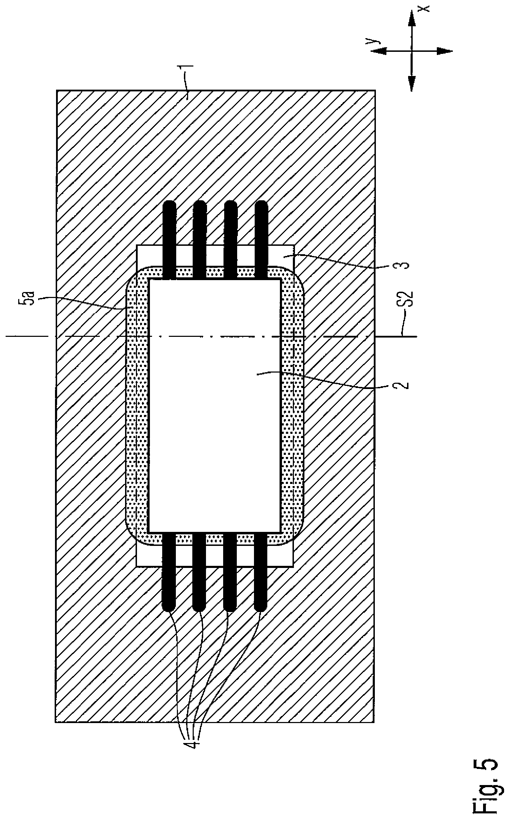

Fig. 5 zeigt eine Leiterplatte 1 mit einem induktiven Bauelement 2 hilfreich für das Verständnis eines zweiten Ausführungsbeispiels gemäß der vorliegenden Erfindung in der Sicht von oben. In dem in Fig. 5 gezeigten Beispiel ist der Abstandhalter 5a als eine von unten auf das quaderförmige Bauelement 2 bzw. dessen Gehäuse aufgeschobene Kappe ausgebildet. Der Abstandhalter 5a kann vor dem Einsetzen des induktiven Bauelements 2 in den Ausschnitt 3 an dem Gehäuse durch Kraft- oder Formschluss angebracht oder erst in dem Ausschnitt 3 angeordnet und danach gleichzeitig mit dem Einsetzen des induktiven Bauelements 2 in den Ausschnitt 3 aufgeschoben werden.

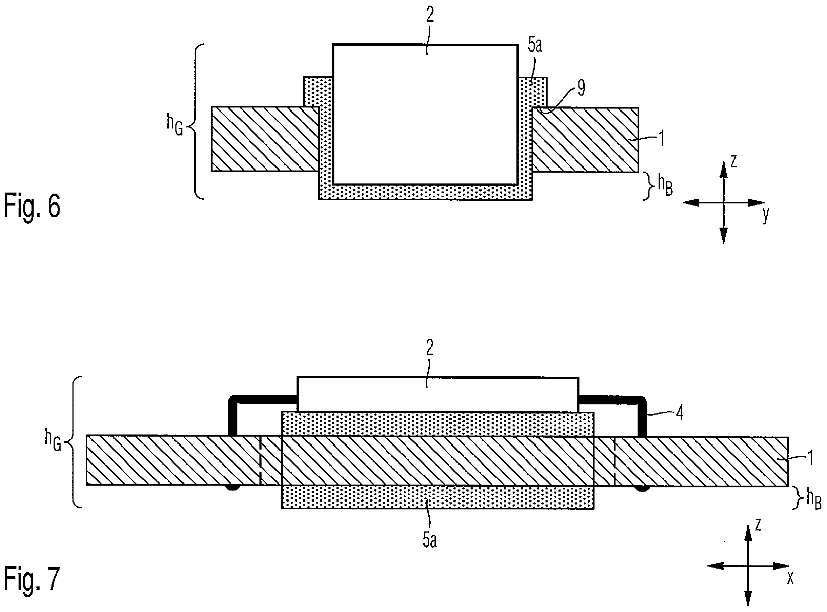

Fig. 6 zeigt eine Schnittdarstellung gemäß der in Fig. 5 gezeigten Schnittlinie S2. Wie in Fig. 6 gezeigt weist der Abstandhalter 5a an seinem oberen Ende an den Längsseiten jeweils einen Absatz 9 (Verdickung) auf, mit dem sich der Abstandhalter 5a in vertikaler Richtung (z) nach unten abstützt. Die vertikale Position des Absatzes 9 (der Kante) bezüglich der Leiterplatte 1 und des Bauelements 2 bestimmt die Höhe h_{B}, mit der das Bauelement 2 nach unten (bzw. nach oben) aus der Leiterplatte 1 herausragt und kann je nach Anwendung/Bedarf variiert werden. In dem gezeigten Beispiel liegt der Abstandhalter 5a auch in horizontaler Richtung (y) an der Leiterplatte 1 an, so dass hierbei auch eine horizontale Postierung des Bauelements 2 bezüglich der Leiterplatte 1 erfolgt. Der Abstandhalter 5a ist an seiner Unterseite geschlossen (Kappe) bzw. umschließt die Unterseite des Bauelements 2. Es ist jedoch auch möglich den Abstandhalter 5a als Hülse auszubilden, bei der zumindest ein Teil der Unterseite des Bauelements 2 und ggf. auch Teile der Seitenflächen des Bauelements 2 freiliegen. Alternativ kann der Absatze 9 (die Kante) an dem Gehäuse angeformt bzw. Bestandteil des Teil des Gehäuses sein. Somit ist kein zusätzliches Bauteil als Abstandhalter 5a nötig. Das Gehäuse des Bauelements 2 kann aus einem Kunststoff im Spritzgussverfahren hergestellt sein.

Fig. 7 zeigt eine Seitenansicht in y-Richtung (keine Schnittdarstellung) der in Fig. 5 gezeigten Leiterplatte 1, wobei die horizontale Position des Ausschnitts 3 durch die gestrichelte Linie angedeutet ist. Wie in Fig. 7 gezeigt, liegt der Abstandhalter 5a nicht an den an den kurzen Seiten des Bauelements 2 befindlichen Anschluss-Drähten 4 an.

Es ist jedoch auch möglich, zusätzlich zumindest einen der in Fig. 3a oder 3b gezeigten Abstandhalter 5 an den Anschluss-Drähten 4 des in Fig. 5 gezeigten Bauelements 2 anzubringen.

## Patentansprüche

1. Induktives Bauelement zum Einlöten auf eine Leiterplatte (1), mit
an dem Bauelement (2) seitlich angeordneten Anschluss-Drähten (4); und einem an zumindest einem der Anschluss-Drähte (4) angeordneten Abstandhalter (5) zum Positionieren des Bauelements (2) auf der Leiterplatte (1) bezüglich der Höhe, wobei der Abstandhalter (5) von dem Anschluss-Draht (4) gehalten wird, sich an der Leiterplatte (1) in vertikaler Richtung (z) abstützt, wenn das Bauelement (2) zum Einlöten auf die Leiterplatte (1) aufgesetzt ist und eine Bohrung (6), durch die der Anschluss-Draht (5) hindurchführt, aufweist,
**dadurch gekennzeichnet, dass**
das aus der Bohrung (6) ragende Ende des Anschluss-Drahts (4) in Richtung der Leiterplatte (1) gebogen ist.

2. Induktives Bauelement nach Anspruch 1, wobei
der Abstandhalter (5) zumindest einen Absatz (8) aufweist, mittels dem sich der Abstandhalter (5) an der Leiterplatte (1) in einer horizontalen Richtung (x, y) abstützt, wenn das Bauelement (2) zum Einlöten in einen Ausschnitt (3) der Leiterplatte (1) eingeführt ist.

3. Induktives Bauelement nach Anspruch 1 oder 2, wobei
an gegenüberliegenden Seiten des Bauelements (2) Anschluss-Drähte (4) angeordnet sind und jeweils ein Abstandhalter (5) an jeder der gegenüberliegenden Seiten von den Anschluss-Drähten (4) gehalten wird.

4. Induktives Bauelement nach Anspruch 1, wobei
das Bauelement (2) ein Gehäuse und zumindest einem an dem Gehäuse angeordneten Abstandhalter (5a) zum Positionieren des Bauelements (2) auf der Leiterplatte (1) bezüglich der Höhe aufweist, und sich der an dem Gehäuse angeordnete Abstandhalter (5a) an der Leiterplatte (1) in vertikaler Richtung (z) abstützt, wenn das Bauelement (2) zum Einlöten auf die Leiterplatte (1) aufgesetzt ist.

5. Induktives Bauelement nach Anspruch 4, wobei
der an dem Gehäuse angeordnete Abstandhalter (5a) Teil des Gehäuses bzw. an dem Gehäuse abgeformt ist.

6. Induktives Bauelement nach Anspruch 4, wobei
der an dem Gehäuse angeordnete Abstandhalter (5a) eine an dem Gehäuse befestigte Hülse oder Kappe ist.

7. Induktives Bauelement nach einem der Ansprüche 4 bis 6, wobei
die Anschluss-Drähte (4) an gegenüberliegenden Seiten des Bauelements (2) angeordnet sind und sich der an dem Gehäuse angeordnete Abstandhalter (5a) jeweils zwischen den gegenüberliegenden Seiten an der Leiterplatte (1) in vertikaler Richtung (z) abstützt, wenn das Bauelement (2) zum Einlöten auf die Leiterplatte (1) aufgesetzt ist.

8. Induktives Bauelement nach einem der Ansprüche 1 bis 7, wobei
das induktive Bauelement (2) eine Planarspule oder ein Planartransformator ist.

9. Leiterplatte mit zumindest einem induktiven Bauelement (2) nach einem der Ansprüche 1 bis 8.

10. Leiterplatte nach Anspruch 9, wobei
die Leiterplatte (1) einen Ausschnitt (3) aufweist, in dem das induktive Bauelement (2) angeordnet ist.

## Claims

1. Inductive component for soldering onto a printed circuit board (1), comprising
connection wires (4) arranged on the side of the component (2); and a spacer (5), arranged at least on one of the connection wires (4), for positioning the component (2) on the printed circuit board (1) with respect to height, wherein the spacer (5) is held by the connection wire (4), is supported on the printed circuit board (1) in the vertical direction (z) when the component (2) is placed on the printed circuit board (1) for soldering, and has a bore hole (6) through which the connection wire (5) passes,
**characterized in that**
the end of the connection wire (4) projecting out of the bore hole (6) is bent in the direction of the printed circuit board (1).

2. Inductive component according to Claim 1, wherein
the spacer (5) has at least one shoulder (8) by means of which the spacer (5) is supported on the printed circuit board (1) in a horizontal direction (x, y) when the component (2) is inserted into a cutout (3) of the printed circuit board (1) for soldering.

3. Inductive component according to Claim 1 or 2, wherein
connection wires (4) are arranged on opposite sides of the component (2), and a respective spacer (5) is held on each of the opposite sides by the connection wires (4).

4. Inductive component according to Claim 1, wherein
the component (2) has a housing and at least one spacer (5a), arranged on the housing, for positioning the component (2) on the printed circuit board (1) with respect to height, and the spacer (5a) arranged on the housing is supported on the printed circuit board (1) in the vertical direction (z) when the component (2) is placed on the printed circuit board (1) for soldering.

5. Inductive component according to Claim 4, wherein
the spacer (5a) arranged on the housing is formed as part of the housing or is formed on the housing.

6. Inductive component according to Claim 4, wherein
the spacer (5a) arranged on the housing is a sleeve or cap fixed to the housing.

7. Inductive component according to any of Claims 4 to 6, wherein
the connection wires (4) are arranged on opposite sides of the component (2), and the spacer (5a) arranged on the housing is respectively supported between the opposite sides on the printed circuit board (1) in the vertical direction (z) when the component (2) is placed on the printed circuit board (1) for soldering.

8. Inductive component according to any of Claims 1 to 7, wherein
the inductive component (2) is a planar coil or a planar transformer.

9. Printed circuit board having at least one inductive component (2) according to any of Claims 1 to 8.

10. Printed circuit board according to Claim 9, wherein
the printed circuit board (1) has a cutout (3) in which the inductive component (2) is arranged.

## Revendications

1. Composant inductif destiné à être soudé sur une carte de circuit imprimé (1), comprenant
des fils de connexion (4) disposés sur le côté du composant (2) ; et un écarteur (5) disposé sur au moins un des fils de connexion (4) pour positionner le composant (2) sur la carte de circuit imprimé (1) en termes de hauteur, l'écarteur (5) étant maintenu par le fil de connexion (4), s'appuyant sur la carte de circuit imprimé (1) dans la direction verticale (z) lorsque le composant (2) est placé sur la carte de circuit imprimé (1) en vue du soudage et comprenant un trou (6), par lequel passe le fil de connexion (5),
**caractérisé en ce que**
l'extrémité du fil de connexion (4) dépassant du trou (6) est courbée en direction de la carte de circuit imprimé (1).

2. Composant inductif selon la revendication 1, dans lequel
l'écarteur (5) comporte au moins un épaulement (8), au moyen duquel l'écarteur (5) s'appuie sur la carte de circuit imprimé (1) dans une direction horizontale (x, y) lorsque le composant (2) est introduit dans une découpe (3) de la carte de circuit imprimé (1) en vue du soudage.

3. Composant inductif selon la revendication 1 ou 2, dans lequel
des fils de connexion (4) sont disposés sur des côtés opposés du composant (2) et un écarteur (5) est respectivement maintenu sur chacun des côtés opposés par les fils de connexion (4).

4. Composant inductif selon la revendication 1, dans lequel
le composant (2) comporte un boîtier et au moins un écarteur (5a) disposé sur le boîtier pour positionner le composant (2) sur la carte de circuit imprimé (1) en termes de hauteur, et l'écarteur (5a) disposé sur le boîtier s'appuie sur la carte de circuit imprimé (1) dans la direction verticale (z) lorsque le composant (2) est placé sur la carte de circuit imprimé (1) en vue du soudage.

5. Composant inductif selon la revendication 4, dans lequel
l'écarteur (5a) disposé sur le boîtier fait partie du boîtier ou est moulé sur le boîtier.

6. Composant inductif selon la revendication 4, dans lequel
l'écarteur (5a) disposé sur le boîtier est une douille ou un capuchon fixé(e) au boîtier.

7. Composant inductif selon l'une des revendications 4 à 6, dans lequel
les fils de connexion (4) sont disposés sur des côtés opposés du composant (2) et l'écarteur (5a) disposé sur le boîtier s'appuie respectivement entre les côtés opposés sur la carte de circuit imprimé (1) dans la direction verticale (z) lorsque le composant (2) est placé sur la carte de circuit imprimé (1) en vue du soudage.

8. Composant inductif selon l'une des revendications 1 à 7, dans lequel
le composant inductif (2) est une bobine planaire ou un transformateur planaire.

9. Carte de circuit imprimé comprenant au moins un composant inductif (2) selon l'une des revendications 1 à 8.

10. Carte de circuit imprimé selon la revendication 9, dans laquelle
la carte de circuit imprimé (1) comporte une découpe (3), dans laquelle le composant inductif (2) est disposé.
